# EUROPEAN PATENT APPLICATION

(11) **EP 4 589 654 A1**
(43) Date of publication of application: **23.07.2025**
(21) Application number: 24210477.6
(22) Date of filing: 04.11.2024
(51) Int. Cl.: H01L 23/48, B22F 1/14

(54) **PRESSURELESS SINTERING METHOD FOR THE CONNECTION OF ELECTRONIC COMPONENTS**

(30) Priority: 22.01.2024 SG 10202400179T
(71) Applicant: Heraeus Materials Singapore Pte. Ltd., 569881 Singapore (SG)
(72) Inventor: Balasubramanian, Senthil Kumar, 569881 Singapore (SG); Bayaras, Abito Danila, 569881 Singapore (SG); Liu, Yu, 569881 Singapore (SG); Tan, Tze Qing, 569881 Singapore (SG); Kang, Sungsig, 569881 Singapore (SG)
(74) Representative: Heraeus IP

(57) **Abstract**

A method for the connection of electronic components, in which (a) a sandwich arrangement is provided, which comprises at least (a1) an electronic component 1, (a2) an electronic component 2, and (a3) a metal sintering preparation being situated between metal contact surfaces of the electronic components 1 and 2, and in which (b) the sandwich arrangement is being pressureless sintered, wherein the method takes place in an ambient gas atmosphere, and wherein an exchange of the ambient gas atmosphere is made within the course of the pressureless metal sintering process.

## Description

The present invention relates to a pressureless sintering method for the connecting (joining) of electronic components, in which process a metal sintering preparation is used as connecting material and in which an ambient gas atmosphere is exchanged during the sintering process.

The term "pressureless" used herein means "without applying mechanical pressure".

Sintering shall be understood to mean the connecting of electronic components by heating without the metal of the metal sintering preparation reaching the liquid phase. Needless to say for the expert that the heating and the sintering happens in an oven.

The term "electronic component" used herein refers to substrates and to active and passive components being used in electronics. As is conventional for electronic components, they have a metal contact surface. In as far as the electronic components do not consist of metal, their contact surfaces are covered by a metal or metallization layer. In an embodiment, the metal contact surfaces can be made of a non-precious metal such as, for example, copper, nickel or aluminum. In another embodiment, the metal contact surfaces can be made of a precious metal such as silver or gold.

Examples of substrates include IMS (insulated metal substrates), AMB substrates (active metal brazed substrates), metal ceramic substrates, e.g. DCBs (direct copper bonded substrates), ceramic substrates, PCBs (printed circuit boards) and leadframes.

Examples of active components include diodes, LEDs (light emitting diodes), dies, IGBTs (insulated gate bipolar transistors), MOSFETs (metal oxide semiconductor field effect transistors), and ICs (integrated circuits).

Examples of passive components include sensors, baseplates, heat sinks, resistors, capacitors, inductors, antennae and connecting elements (e.g. clips).

The term "ambient gas atmosphere" used herein denotes that the pressureless sintering method for the connection of electronic components disclosed herein does of course not take place in a vacuum; rather, it takes place in a gas atmosphere, in particular in a gas atmosphere at standard pressure.

It has been disclosed that silver sinter joints can be formed on bare copper surfaces without applying mechanical pressure (i.e. pressure-less) during a sintering process using a sinter paste based on silver nanoparticles or based on a mixture of silver microparticles (typically in the range of 1 to 10 µm in size) and silver nanoparticles (typically in the range of 1 to 100 nanometer in size). Examples of such disclosures comprise: H. Miyoshi, K. Endoh, S. Kurita, "Application of Silver Nano Particles to Pressureless Bonding onto a Copper Surface - Consideration of Substitute Material for Lead Solder", CIPS conference 2014; H. Zheng, D. Berry, K.D.T. Ngo, G. Lu, "Chip-Bonding on Copper by Pressureless Sintering of Nanosilver Paste Under Controlled Atmosphere", IEEE Transactions on Electronic components, Packaging and Manufacturing Technology, Vol. 4, No. 3, March 2014; H. Zheng, J. Calata, K. Nog, S. Luo, G. Lu, "Low-pressure (< 5 MPa) Low-temperature Joining of Large-area Chips on Copper Using Nanosilver paste", CIPS conference 2012; and T. Watanabe, N. Nakajima, M. Takesue, "Material Design and Process Conditions of Pressureless Sintered Silver for 200/40°C Thermal Cycling Reliability", PCIM Europe 2017.

There are also many patent documents disclosing pressureless metal sinter connecting processes, e.g. WO 2018/206267 A1 and WO 2018/206162 A1. Other patent documents disclose metal sintering preparations which have a composition that allows them to be used in a metal sintering connection process or even explicitly to be used in a pressureless metal sintering connection process. Examples of such patent documents include WO 2022/214228 A1, WO 2022/128177 A1, WO 2021/073803 A1 and WO 2020/057806 A1.

It is an object of the invention to provide a pressureless metal sintering method for the connection of electronic components in reliable manner. The method should be feasible with practically any metal sintering preparation, i.e. without having to use a metal sintering preparation specially adapted for the connection of electronic components by pressureless metal sintering. As has already been mentioned, such metal sintering connection happens via metal contact surfaces of the electronic components. In particular, the pressureless metal sintering method to be found shall be well-suited for reliably pressureless connecting electronic components at least one of which having a non-precious metal contact surface like a copper contact surface. Formation of reliable connections should be enabled even on non-pretreated non-precious metal contact surfaces of electronic components during pressureless metal sintering.

It has now been found that an exchange of the ambient gas atmosphere made within the course of a pressureless metal sintering process for the connection of electronic components has an unexpected and surprising positive effect on the strength of the connection between the electronic components.

The invention relates to a method for the connection of electronic components, in which (a) a sandwich arrangement is provided, which comprises at least (a1) an electronic component 1, (a2) an electronic component 2, and (a3) a metal sintering preparation being situated between metal contact surfaces of the electronic components 1 and 2, and in which (b) the sandwich arrangement is being pressureless sintered. The entire method of the invention takes place in an ambient gas atmosphere, wherein an exchange of the ambient gas atmosphere is made within the course of the pressureless metal sintering process, i.e. within the course of step (b).

The metal sintering process of step (b) comprises three successive or in particular three directly successive phases or sub-steps (b1) to (b3), i.e. a heating-up sub-step (b1), a sub-step (b2) at peak temperature (maximum object temperature, i.e. maximum temperature of the sandwich arrangement), and a cooling-down sub-step (b3). Sub-steps (b1), (b2) and, optionally, also sub-step (b3) are carried out in an oven.

It is essential for the invention, that an exchange of the ambient gas atmosphere is made within the course of the pressureless metal sintering process, i.e. during metal sintering step (b) in which the sandwich arrangement is being pressureless sintered. To be more precise, the exchange of the ambient gas atmosphere can be made either within sub-step (b2) or at the start of sub-step (b3). "Within sub-step (b2)" means "after at least 5 minutes of the duration of sub-step (b2) have elapsed" or it may mean "around the middle of sub-step (b2)", i.e. after 40 to 60 % of the duration of sub-step (b2) have elapsed. Preferably, the exchange of the ambient gas atmosphere is made at the start of sub-step (b3).

The expression "exchange of the ambient gas atmosphere" means the exchange or replacement of a first ambient gas or gas mixture by a second ambient gas or gas mixture of different composition or it may mean a compositional change of a first ambient gas or gas mixture so as to obtain a second ambient gas mixture, i.e. first ambient gas or gas mixture and second ambient gas or gas mixture differ in composition. The first ambient gas (mixture) can be an oxidizing or a non-oxidizing gas (mixture) and, accordingly, the second ambient gas (mixture) is then a non-oxidizing or an oxidizing gas (mixture). The exchange of the ambient gas atmosphere happens at least one time, i.e. an exchange of an ambient non-oxidizing gas atmosphere by an ambient oxidizing gas atmosphere or vice versa, i.e. an exchange of an ambient oxidizing gas atmosphere by an ambient non-oxidizing gas atmosphere. The exchange of the ambient gas atmosphere may happen more often than one time; however, typically and preferably it happens only once. The exchange of the ambient gas atmosphere can be made by purging the inner of the oven, i.e. by purging the inner of the oven with the subsequent gas type; however, in another embodiment the exchange of the ambient gas atmosphere can be made by not completely purging the inner of the oven but by only partially displacing the ambient gas atmosphere in the oven by injecting a gas or gas mixture of different composition into the oven, or - to be more precise - by only partially displacing the first ambient gas or gas mixture in the oven by injecting a gas or gas mixture of different composition into the oven so as to obtain the second ambient gas mixture, i.e. a second ambient gas mixture of a desired composition. Purging is the preferred gas exchange method. Examples of non-oxidizing gas atmospheres include oxygen-free reducing gas atmospheres like a hydrogen/nitrogen or formic acid/nitrogen gas mixture and oxygen-free inert gas atmospheres comprised of at least one inert gas, for example, nitrogen, carbon dioxide, a noble gas, e.g. argon. An oxygen-free gas atmosphere shall be understood to mean a gas atmosphere whose oxygen content is no more than 300 vol.ppm (ppm by volume), preferably no more than 200 vol.ppm, and even more preferably no more than 100 vol.ppm. Examples of oxidizing gas atmospheres include gas mixtures of at least one inert gas comprising 10 to 50 vol.% (percent by volume) oxygen, preferably 10 to 30 vol.% oxygen; air is an example of a preferred oxidizing gas atmosphere.

Connecting electronic components shall be understood to mean attaching an electronic component on a second electronic component. In this context, "on" simply means that a metal contact surface of the first electronic component is being connected to a metal contact surface of the second electronic component regardless of the relative disposition of the two electronic components or of the sandwich arrangement comprising the at least two electronic components.

As regards the electronic components and their metal contact surfaces, reference is made to what has been disclosed above. The method of the invention is used to particular advantage, when electronic components 1 and/or 2 have a non-precious metal contact surface, in particular a copper contact surface. Hence, in a specific and advantageous embodiment of the method of the invention the metal of at least one of the metal contact surfaces of the electronic components 1 and 2 to be connected is copper, which may or may not have been pretreated.

The electronic components 1 and 2 to be connected can be identical or different electronic components. As has already been said, the present invention facilitates not only the connection of precious metal contact surfaces of the electronic components 1 and 2, but also, in particular, the connection of a non-precious metal contact surface, in particular a copper contact surface, to a precious metal contact surface or even the connection of two non-precious metal contact surfaces of the electronic components 1 and 2 in a manner that results in a reliable connection at room temperature and at elevated temperatures, such as, from 200 to 260°C. For example, aluminum-nickel, aluminum-copper, aluminum-silver, aluminum-aluminum, aluminum-gold, copper-silver, copper-nickel, copper-copper, copper-gold, silver-nickel, silver-gold, silver-silver or gold-gold connections can be formed. The terms "aluminum, copper, nickel, silver and gold metal contact surfaces" include metal contact surfaces made of alloys of said metals. Just like in case of silver, gold or other precious metal contact surfaces, even in case of non-precious metal contact surfaces like copper, nickel or aluminum surfaces there is no need for a pretreatment thereof prior to carrying out the sintering step (b), and there is especially no need for a reductive pretreatment prior to carrying out the sintering step (b).

The term "room temperature" used herein denotes a temperature in the range of 20 to 35 °C.

Accordingly, if two electronic components, i.e. electronic component 1 and electronic component 2, are to be connected to each other, the metal sintering preparation is situated between the metal contact surfaces of electronic component 1 and electronic component 2 prior to performing the sintering process of step (b). On the other hand, it is conceivable to connect more than two electronic components to each other. For example, three electronic components, i.e. electronic component 1, electronic component 2 and an electronic component 3, can be connected to each other in appropriate manner such that electronic component 2 is situated between electronic component 1 and electronic component 3. In this case, the metal sintering preparation is situated between both electronic component 1 and electronic component 2 as well as between electronic component 2 and electronic component 3, or, to be more precise, between the metal contact surfaces thereof, wherein here, in this scenario, electronic component 2 has two metal contact surfaces of course.

Preferably, first, the metal contact surface of electronic component 1 or 2 is provided with the metal sintering preparation of the invention. Accordingly, then the other electronic component 2 or 1 is placed by its metal contact surface on the metal sintering preparation that has been applied to the metal contact surface of the electronic component 1 or 2.

Metal sintering preparations for the connection of electronic components are well known to the skilled person; examples include metal sintering preforms and in particular metal sintering pastes. A metal sintering preform is a foil-like piece of solidified, e.g. dried and not or only partly sintered metal sintering paste. It can be made by applying metal sintering paste onto a flat carrier, drying the so applied metal sintering paste without or without completely sintering it and thereafter peeling it off. A metal sintering paste comprises metal particles, organic solvent and optionally but typically also at least one additive, examples of which may include metal precursors, wetting additives, dispersion agents, surfactants, defoaming agents, viscosity-controlling (rheological) agents and sintering agents. Any such conventional metal sintering preparation may be used in the method of the invention. There is no need for the metal sintering preparation to be specially adapted for the connection of electronic components by pressureless metal sintering. However, it may of course be specially adapted for the connection of electronic components by pressureless metal sintering. Preferred as metal sintering preparations are copper sintering preparations and in particular silver sintering preparations; most preferred as metal sintering preparations are copper sintering pastes and in particular silver sintering pastes. Examples of patent documents disclosing copper sintering preparations and silver sintering preparations and their composition include WO 2020/057806 A1, WO2011/026623 A1, WO2016/028221 A1, US 2017/0243849 A1 and US 2018/0056449 A1 to name only a few.

In case of performing the method of the invention with a metal sintering paste, the application thereof onto the metal contact surface of the electronic component 1 or 2 can be performed by means of conventional methods. Examples include dispensing, screen printing, stencil printing, pin transfer and dipping. Preferably, the thickness of the wet layer of the metal sintering paste between the electronic components 1 and 2 to be connected is in the range of 50 to 150 µm. In this context, thickness of the wet layer shall be understood to mean the layer thickness prior to drying, if any, and prior to sintering step (b). The preferred wet layer thickness depends on the method selected for applying the metal sintering paste. If the metal sintering paste is applied, for example, by means of screen printing or dispensing, the wet layer thickness can preferably be in the range of 50 to 80 µm. If the metal sintering paste is applied by means of stencil printing, the preferred wet layer thickness can be in the range of 50 to 100 µm. Once the metal sintering paste has been applied, an optional drying step can be introduced prior to the sintering step (b), i.e. organic solvent is then removed from the applied metal sintering paste. The drying step can be performed prior to forming the sandwich arrangement, i.e. after application of the metal sintering paste to the metal contact surface of electronic component 1 and before connecting with the metal contact surface of electronic component 2, or after assembling of the sandwich arrangement. According to a preferred embodiment, the fraction of organic solvent in the metal sintering paste after drying is, for example, 0 to 5 wt.-% with respect to the original fraction of organic solvent in the metal sintering paste, i.e. in the metal sintering paste ready for application. In other words, according to said preferred embodiment, for example, 95 to 100 wt.-% of the organic solvent that is originally present in the metal sintering paste are removed during drying. The drying temperature can be in the range of, for example, 100 to 150 °C. Common drying times are in the range of, for example, 5 to 45 minutes.

In case of performing the method of the invention with a metal sintering preform, the application thereof onto the metal contact surface of the electronic component 1 or 2 can be performed by simply placing it between the metal contact surfaces of the electronic components 1 and 2 to be connected to each other.

The sandwich arrangement of the at least two electronic components 1 and 2 and the metal sintering preparation situated between their metal contact surfaces is finally subjected to a metal sintering process in step (b) in the course of which the sandwich arrangement is being pressure-less sintered. Step (b) (i.e. at least sub-steps (b1) and (b2)) is typically carried out in an oven, which may be a stationary oven or a conveyor oven. In case of a stationary oven, the sandwich arrangement is placed in the oven and it experiences a heating-up process until it reaches a peak temperature, i.e. a maximum object temperature, typically in the range of, for example, 200 to 250 °C. After the peak temperature phase a cooling-down phase follows. In case of a conveyor oven, the sandwich arrangement is transported through the oven in the course of which transportation process it undergoes a heating-up process until it reaches its peak temperature in said range of, for example, 200 to 250 °C, wherein the oven temperature can be constant or may constantly or step-wise increase during the transport of the sandwich arrangement through the oven.

As has already been disclosed, the metal sintering process of step (b) comprises three successive or, in particular, three directly successive phases or sub-steps (b1) to (b3), i.e. a heating-up sub-step (b1), a sub-step (b2) at peak temperature in said range of, for example, 200 to 250 °C, and a cooling-down sub-step (b3). The cooling-down sub-step (b3) is typically performed as a passive cooling, i.e. without taking active cooling measures. Those sub-steps may be characterized by the following features:

| Sub-step | Duration | Object temperature | (Preferably uniform) heating-up rate | (Preferably uniform) cooling-down rate |
|---|---|---|---|---|
| (b1) | within a range of, for example, 30 to 60 minutes | from room temperature to below peak temperature | within a range of, for example, 3 to 5 K min⁻¹ | within a range of, for example, 3 to 5 K min⁻¹ |
| (b2) | within a range of, for example, 30 to 60 minutes | (preferably constant) peak temperature within a range of, for example, 200 to 250 °C | Not applicable | Not applicable |
| (b3) | within a range of, for example, 30 to 60 minutes | from peak temperature to room temperature | within a range of, for example, 3 to 5 K min⁻¹ | within a range of, for example, 3 to 5 K min⁻¹ |

Regardless of the metal contact surface type of the electronic components 1 and 2 to be connected, the actual pressureless sintering process can proceed at a peak temperature in said range of, for example, 200 to 250 °C with or without pretreatment of the precious metal or non-precious metal contact surfaces of the electronic components 1 and 2. The pressureless sintering mechanism as such may already start in the heating-up phase.

### Examples:

Heraeus Electronics mAgic^{®} DA295A silver sintering paste was used in the examples. Both the nitrogen atmosphere and the air atmosphere each represented an ambient gas atmosphere at standard pressure in the sense of this disclosure.

Application and pressure-free sintering:
The silver sintering paste was applied by means of dispensing onto the copper surface of a lead frame made of a copper-rich copper/iron alloy (96 wt.-% copper, 4 wt.-% Fe) to produce a 50 µm thick wet layer. Then, the applied silver sintering paste was contacted without previous drying to a silicon chip via its 2 mm x 2 mm silver metal contact surface. The subsequent pressure-free sintering took place according to the temperature profiles shown in Table 1. The nitrogen atmosphere comprised ≤ 200 vol.ppm of oxygen. The sandwich arrangement including the contact site was heated steadily with a uniform heating-up rate to 250 °C over the course of 60 minutes and then maintained at 250 °C for a selected duration. Then, the so formed sandwich arrangement was cooled steadily to 30 °C over the course of 50 minutes. The exchange of ambient gas atmosphere was made by purging according to Table 1.

After the sintering, the bonding strength was determined by shear testing. In this context, the electronic components were sheared off with a shearing chisel at a rate of 0.3 mm/s at room temperature and at 260 °C. The force was measured by means of a load cell (DAGE 4000 plus device made by DAGE, Germany). Table 2 shows the results obtained with temperature profiles of Examples 1 to 5.

**Table 1**

| Sub-step | Inventive Example 1 | Inventive Example 2 | Comparative Example 3 | Comparative Example 4 | Comparative Example 5 |
|---|---|---|---|---|---|
| Heating-up sub-step (b1) | Heated up from 30°C to below 250°C in nitrogen atmosphere over a course of 60 minutes | Heated up from 30°C to below 250°C in nitrogen atmosphere over a course of 60 minutes | Heated up from 30°C to below 250°C in nitrogen atmosphere over a course of 60 minutes | Heated up from 30°C to below 250°C in air atmosphere over a course of 60 minutes | Heated up from 30°C to below 250°C in air atmosphere over a course of 60 minutes |
| Sub-step (b2) at peak temperature (250°C) | Maintained at 250°C in nitrogen atmosphere for 30 minutes, then switched to air atmosphere for a further 30 minutes | Maintained at 250°C in nitrogen atmosphere for 30 minutes | Maintained at 250°C in nitrogen atmosphere for 60 minutes | Maintained at 250°C in air atmosphere for 60 minutes | Maintained at 250°C in nitrogen atmosphere for 60 minutes |
| Cooling-down sub-step (b3) | Cooled from 250°C to 30°C in air atmosphere over the course of 50 minutes | Cooled from 250°C to 30°C in air atmosphere over the course of 50 minutes | Cooled from 250°C to 30°C in nitrogen atmosphere over the course of 50 minutes | Cooled from 250°C to 30°C in air atmosphere over the course of 50 minutes | Cooled from 250°C to 30°C in nitrogen atmosphere over the course of 50 minutes |

**Table 2**

| | Inventive Example 1 | Inventive Example 2 | Comparative Example 3 | Comparative Example 4 | Comparative Example 5 |
|---|---|---|---|---|---|
| Shear strength at room temperature (N/mm²) | 35.2 | 35.3 | 8.3 | <2 | <2 |
| Shear strength at 260°C (N/mm²) | 34.9 | 34.7 | 35.6 | <2 | <2 |

## Claims

1. A method for the connection of electronic components, in which (a) a sandwich arrangement is provided, which comprises at least (a1) an electronic component 1, (a2) an electronic component 2, and (a3) a metal sintering preparation being situated between metal contact surfaces of the electronic components 1 and 2, and in which (b) the sandwich arrangement is being pressureless sintered, wherein the method takes place in an ambient gas atmosphere, and wherein an exchange of the ambient gas atmosphere is made within the course of the pressureless metal sintering process.

2. The method of claim 1, wherein step (b) comprises three successive sub-steps (b1) to (b3), namely a heating-up sub-step (b1), a sub-step (b2) at peak temperature, and a cooling-down sub-step (b3), wherein at least sub-steps (b1) and (b2) are carried out in an oven.

3. The method of claim 1 or 2, wherein electronic components 1 and/or 2 have a non-precious metal contact surface, wherein the non-precious metal is copper, nickel or aluminum.

4. The method of claim 1, 2 or 3, wherein the metal sintering preparation is a metal sintering preform or a metal sintering paste.

5. The method of claim 2, 3 or 4, wherein the exchange of the ambient gas atmosphere is made either within sub-step (b2) or at the start of sub-step (b3).

6. The method of any one of the preceding claims, wherein the exchange of the ambient gas atmosphere means an exchange of an ambient non-oxidizing gas atmosphere by an ambient oxidizing gas atmosphere or vice versa.

7. The method of any one of the preceding claims, wherein the exchange of the ambient gas atmosphere happens once or more than one time.

8. The method of any one of the preceding claims 2 to 7, wherein the exchange of the ambient gas atmosphere is made by purging the inner of the oven or by only partially displacing it in the oven by injecting a gas or gas mixture of different composition into the oven.
